# EUROPÄISCHE PATENTSCHRIFT

(11) **EP 2 353 193 B1**
(45) Veröffentlichungstag und Bekanntmachung des Hinweises auf die Patenterteilung: **20.04.2016**
(21) Anmeldenummer: 09775090.5
(22) Anmeldetag: 26.11.2009
(51) Int. Cl.: H01L 31/18, H01L 21/67, B07C 5/344

(54) **VERFAHREN UND VORRICHTUNG ZUM VOLLAUTOMATISCHEN SELEKTIEREN UND VERPACKEN VON PHOTOVOLTAISCHEN MODULEN**
METHOD AND DEVICE FOR FULLY AUTOMATICALLY SELECTING AND PACKING PHOTOVOLTAIC MODULES
PROCÉDÉ ET DISPOSITIF DE SÉLECTION ET D'EMBALLAGE ENTIÈREMENT AUTOMATIQUES DE MODULES PHOTOVOLTAÏQUES

(30) Priorität: 01.12.2008 DE 102008059793
(43) Veröffentlichungstag der Anmeldung: 10.08.2011
(73) Patentinhaber: Grenzebach Maschinenbau GmbH, 86663 Asbach-Bäumenheim (DE)
(72) Erfinder: ROSSMANN, Thomas, 86690 Merlingen (DE); WENNINGER, Egbert, 86641 Rain (DE)
(74) Vertreter: Kindermann, Peter
(86) Internationale Anmeldenummer: PCT/DE2009/001679
(87) Internationale Veröffentlichungsnummer: WO 2010/063263

(56) Entgegenhaltungen:
- EP-A1- 1 647 827
- EP-A2- 0 111 394
- EP-A2- 1 006 061
- WO-A1-2009/053783
- DE-A1- 19 952 195
- DE-A1-102005 046 216
- JP-A- 2001 091 567
- JP-A- 2002 166 234
- US-A- 5 085 030
- US-A- 5 414 978
- US-A1- 2005 011 779
- US-A1- 2006 292 846
- US-B1- 6 265 242

## Beschreibung

Die Erfindung betrifft das vollautomatische Selektieren und Verpacken von photovoltaischen Modulen, bzw. Solarmodulen, die in Großserie hergestellt werden.

Moderne Glasfassaden sind vielfach nicht nur ein Funktionselement eines Baukörpers sondern dienen zunehmend auch zur solaren Stromerzeugung. Maßgeschneiderte Solarmodule ermöglichen die passgenaue Integration in Bauwerksraster und Profile. Semitransparente Solarzellen, aber auch opake Solarzellen mit transparenten Bereichen, lassen Photovoltaik - Verglasungen lichtdurchflutet erscheinen. Die Solarzellen übernehmen dabei häufig den gewünschten Effekt des Sonnen - und Blendschutzes.
Die Herstellung von solchen Photovoltaik - Anlagen erfordert Arbeitsbedingungen wie sie vor allem bei der Herstellung von Halbleitern und integrierten elektronischen Schaltungen üblich sind. Diese so genannten Reinraum - Bedingungen machen bei der Fertigung von Photovoltaik - Anlagen auch zusätzlich die Handhabung flächenmäßig großer stoßempfindlicher Glasplatten erforderlich.
Bei einem photovoltaischen Modul handelt es sich, von außen betrachtet, um die Verbindung einer Substratplatte aus Glas, eines photovoltaischen Elements und einer Glasplatte als Deckglas mittels einer, unter Wärmeeinwirkung diese Glasplatten verklebenden, Folie oder eines Klebers.
Die Herstellung photovoltaischer Anlagen ist noch relativ teuer. Es besteht deshalb das Bestreben die Herstellung photovoltaischer Module in großen Serien herzustellen und somit die Kosten zu reduzieren.
Bei einer Fertigung solcher photovoltaischer Module in großen Stückzahlen ist es nicht zu vermeiden, dass Produkte unterschiedlicher Qualitätsstufen entstehen. Die Einordnung nach bestimmten Qualitätskriterien erfolgt dabei im Rahmen der Bandbreite bestimmter technischer Eigenschaften, wie der erzielten elektrischen Spannung bei einer bestimmten Beleuchtungsstärke.
Beispielsweise kann die Einordnung in vier verschiedene Qualitätsstufen die Selektion fertiger photovoltaischer Module in die entsprechenden Qualitätsstufen erforderlich machen.

Wenn zudem bei einer gleichzeitigen Herstellung photovoltaischer Module in mehreren Fertigungslinien auf jeder Fertigungslinie Produkte gefertigt werden, die unterschiedlichen Qualitätsstufen zuzuordnen sind, müssen die Produkte die der gleichen Qualitätsstufe angehören, ohnehin deshalb erfasst und diese Informationen zentral gespeichert werden.

Aus der DE 31 05 352 C2 ist eine Anordnung zur Anzeige des Betriebszustandes bei Solarzellen bekannt. Es handelt sich hierbei um Solarzellen die in Modulen zusammengeschaltet sind, wobei wenigstens ein Anzeigeelement parallel zu mindestens einem Modul liegt. Als Aufgabe liegt dieser Anordnung zugrunde, dass kein wesentlicher Verdrahtungsaufwand erforderlich ist und die Anordnung einfach überwacht werden kann. Zur Lösung dieser Aufgabe wird in der DE 31 05 352 C2 vorgeschlagen, dass das Anzeigeelement in das Modul integriert ist.
Ein Hinweis auf das Selektieren und Verpacken photovoltaischer Anlagen ist dieser Druckschrift nicht zu entnehmen.

Aus der DE 93 12 710 U1 ist ein modulares Diagnosesystem zur Erkennung und Lokalisierung von Fehlern in Photovoltaikanlagen bekannt. Es wird hier ein Diagnosesystem zur Fehlererkennung und Fehlerlokalisierung in Photovoltaikanlagen bestehend aus mindestens zwei dezentralen Komponenten, die den Modulen oder Modulgruppen oder Teilen von Modulen zugeordnet sind, beschrieben. Eine solche Diagnoseeinheit weist mindestens eine zentrale Auswerteeinheit auf, die aufgrund der von den zentralen Komponenten übermittelten bzw. erhaltenen Informationen Fehler und Ausfälle in Photovoltaikanlagen ermittelt und anzeigt, wobei die Informationsübertragung über die Energieleitungen erfolgt.
Bei einem solchen Diagnosesystem soll die Fehlererkennung und Fehlerlokalisierung in Photovoltaikanlagen wesentlich vereinfacht werden, ohne zusätzlichen Installationsaufwand bei der Verkabelung der Anlage zu erfordern.
Gelöst wird diese Aufgabe dadurch, dass die dezentralen Komponenten aus, mit den externen Anschlüssen der Module verbundenen, frequenzabhängigen Impedanzen bestehen, deren Frequenzgang charakteristisch für das jeweilige Modul und dessen Betriebszustand ist und die zentrale Auswerteeinheit eine Impedanzmessung der Energieleitungen über den interessierenden Frequenzbereich durchführt, um auf diese Weise Informationen über den Zustand der Anlage zu erhalten.

Eine weitere Lösung gemäß der DE 93 12 710 U1 besteht darin, dass die dezentralen Komponenten aus aktiven Schaltungen bestehen, die eine Wechselspannung oder einen Wechselstrom auf die Anschlüsse des Moduls einprägen bzw. der Gleichspannung oder dem Gleichstrom des Moduls überlagern, wobei Frequenz bzw. Frequenzspektrum der Wechselgröße charakteristisch für das jeweilige Modul und dessen Betriebszustand sind und die zentrale Auswerteeinheit eine Messung des Frequenzspektrums von Spannung und/oder Strom auf den Energieleitungen durchführt und auf diese Weise den Betriebszustand der Anlage ermittelt.
Ein Hinweis auf das Selektieren und Verpacken photovoltaischer Anlagen ist auch dieser Druckschrift nicht zu entnehmen.

In der DE 37 36 560 A1 ist eine Vorrichtung zur Herstellung von Gittern beschrieben. Hier werden Gitter der unterschiedlichsten Formen mittels eines Transfersystems für Werkstückträger automatisiert hergestellt.
In der DE 23 53 031 A1 wird eine Vorrichtung zur Weiterleitung von Gegenständen in einem Winkel, insbesondere für Verarbeitungstrecken von Plattenelementen behandelt. Im Wesentlichen besteht diese aus Fördereinrichtungen und Transportbandeinrichtungen die einfach konstruiert sind und billig hergestellt werden können.
Die DE 40 10 024 betrifft eine Fertigungsanlage mit Parallel- und Nebenförderwegen für die Montage und bzw. oder Bearbeitung von aus mehreren Einzelteilen bestehenden Bauteilen, bei der die Einzelteile und bzw. oder Bauteile auf Paletteneinsätzen angeordnet sind. Zum Zweck der kostengünstigen Herstellung wird hier im Wesentlichen vorgeschlagen einem Parallelförderweg einen parallel verlaufenden Nebenförderweg zuzuordnen, wobei dieser über Knotenstationen mit dem Parallelförderweg und / oder dem Hauptförderweg verbunden ist.
Bei den 3 letztgenannten Druckschriften handelt es sich um einfache Transport- oder Herstellungsmethoden von ebenso einfachen Gegenständen.
Die JP 2002 166234 A offenbart eine Vorrichtung zum vollautomatischen Selektieren und Verpacken von photovoltaischen Solarmodulen die in Großserie hergestellt werden.
Die EP 1 647 827 A1 offenbart ein Testsystem zum Überprüfen der Fertigungsqualität von Solarzellen mit Vorrichtungen zu mechanischen Endprüfungen und elektrischen Endprüfungen.

Die US 2005/0011779 A1 offenbart ein System und ein Verfahren zur hermetischen Verpackung von Glasscheiben mit einer Behandlung der Glasoberflächen, einer chemischen Behandlung der Glasoberflächen gegen Feuchtigkeit und der Anwendung von Schutzmaßnahmen einer Gruppe von aufeinander liegenden Glasplatten gegen Beschädigungen.

In der US 4 986 726 A ist eine Vorrichtung zum automatischen Stapeln und Einordnen von Pakten bestehend aus Platten unterschiedlicher Größe beschrieben. Hierzu wird ein System aus horizontalen und vertikalen Transportmitteln verwendet. Die speziellen Anforderungen bei der Behandlung photovoltaischer Module werden in dieser Druckschrift nicht behandelt.
Die DE 25 23 301 A1 betrifft eine Vorrichtung zur Ablage von Stapelleisten zwischen übereinander liegenden Bretterlagen zur Bildung eines Bretterstapels. Dies betrifft ein unwesentliches Merkmal bei der Lagerung von photovoltaischen Modulen.
In der US 2 963 836 A ist eine Vorrichtung zum automatischen Handhabung und Verpacken von starren und halbstarren Platten beschrieben. Im Wesentlichen handelt es sich hierbei um eine horizontale und vertikale Bewegung von Platten in einem begrenzten tischähnlichen Bereich.

Der erfindungsgemäßen Vorrichtung, bzw. dem erfindungsgemäßen Verfahren liegt deshalb die Aufgabe zugrunde, das Selektieren und Verpacken von photovoltaischen Modulen automatisch gesteuert, zuverlässig und mit schnellen Taktzeiten preiswert zu gewährleisten.

Diese Aufgabe wird mit einer Vorrichtung nach Anspruch 1, bzw. einem Verfahren nach Anspruch 2, gelöst.

Die erfindungsgemäße Vorrichtung wird im Folgenden näher beschrieben.
Es zeigen im Einzelnen:
Fig.1: eine strukturelle Übersicht der erfindungsgemäßen Vorrichtung
Fig.2: die Laufschiene 15 im Querschnitt
Fig.3: eine alternative Lösung der erfindungsgemäßen Vorrichtung

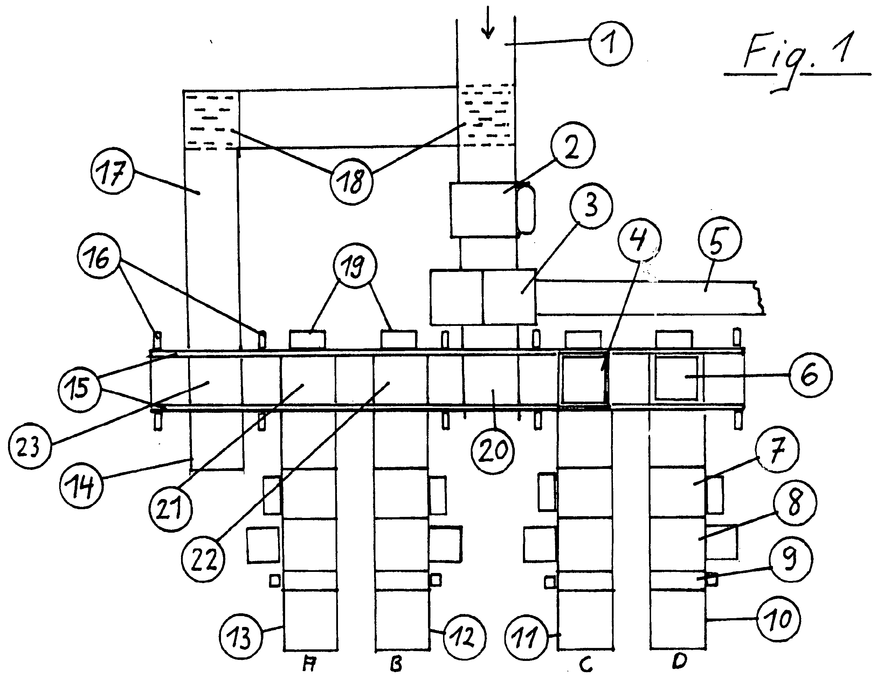

Im oberen Teil der Fig.1 ist die Einmündung einer Produktionslinie 1 in den Abnahme - Bereich dargestellt. Am Ende der Produktionslinie 1 durchläuft jedes photovoltaische Modul die Qualitäts - Prüfungseinrichtung 2. Diese ist notwendig, da der Fertigungsprozess von photovoltaischen Modulen nicht gewährleistet, dass jedes Modul dieselben Leistungsdaten aufweist. Tatsächlich streuen die Leistunsparameter bei photovoltaischen Modulen so stark, dass es sich als notwendig erwiesen hat, die Ausbeute der Produktion in mindestens 4 unterschiedliche Leistungsklassen aufzuteilen.
Die Zuteilung zu diesen Klassen wird in der Qualitäts - Prüfungseinrichtung 2 ermittelt.

In dieser Prüfungseinrichtung 2 können folgende Untersuchungen vorgenommen werden:
1. Messung der Laminierung
2. Unversehrtheit der Scheiben
3. Prüfung der Kontakte
4. elektrische Messung des Wirkungsgrads
5. Verknüpfung mit bestehenden Produktionsdaten

Die Messung der Laminierung und die Unversehrtheit der Scheiben können durch Kameras überwacht werden. Diese Untersuchungen werden schon einmal während der Produktion vorgenommen und können entsprechend dem gewünschten Sicherheitsbedarf an dieser Stelle wiederholt werden. Zusätzlich können an dieser Stelle Rütteltests erfolgen und weitergehende Untersuchungen zur Unversehrtheit mittels Ultraschall vorgenommen werden. Die Prüfung der elektrischen Kontakte und die Messung des Wirkungsgrades erfolgen mittels elektrischer Prüfschaltungen. Zur Ermittlung kalter Lötstellen können punktuelle Kälteeinwirkungen (Kältespray) an elektrischen Übergangsstellen vorgenommen werden. Eine kurz darauf vorgenommene Messung ohmscher und / oder induktiver und / oder kapazitiver Widerstände ergibt zuverlässig Aufschluss über nicht ordentlich ausgeführte Lötstellen. Auf diese Weise können frühzeitig Schwachstellen in der elektrischen Verkabelung ermittelt werden die später oft erst nach längerer Zeit in den Wechselzyklen der Witterung zu plötzlichen Ausfällen führen. Die Verknüpfung des jeweils geprüften photovoltaischen Moduls mit den aus der Produktion bekannten Daten kann elektronisch über Bar - Codes oder Transponder der RFID - Technology erfolgen (RFID = radio frqueny identification).

In der nächsten Station 3, der Montagevorrichtung für Modulträger, wird an dem jeweiligen Modul automatisch ein bestimmter Modulträger befestigt. Der Modulträger stellt die Verbindung von den Glasplatten eines Moduls zu den am jeweiligen Einsatzort bestehenden Montagemöglichkeiten her. Es ist bekannt, dass eine Vielzahl von Befestigungsmöglichkeiten vom jeweiligen Anwender gewünscht wird. Entsprechend dieser unterschiedlichen Befestigungsmöglichkeiten werden auf der Versorgungslinie 5 für Modulträger die entsprechenden unterschiedlichen Arten von Modulträgern bereitgestellt.

Da diesen unterschiedlichen Arten von anzubringenden Modulträgeren zusätzlich unterschiedliche Anforderungen der Anwender hinsichtlich der gewünschten Leistungsklasse entsprechen, ist die Montage der Modulträger erst nach der Ermittlung der jeweiligen Leistungsklasse möglich.
Ein auf diese Weise über einen Bar - Code oder einen Transponder, entsprechend seiner spezifischen Leistungsklasse und seiner spezifischen Art der Befestigung, klassifiziertes photovoltaisches Modul erreicht dann den Aufnahmeplatz 20 der Produktionslinie.
Von diesem Aufnahmeplatz 20 werden die fertigen photovoltaischen Module entsprechend ihrer Leistungsklasse und ihres jeweiligen Modulträgers auf die Abnahmeplätze D,C,B A die in der Figur 1 mit 10,11,12,13 bezeichnet sind, verbracht. Der Abnahmeplatz 14 dient der Lagerung von Ausschuss - Modulen. Diese Transporte werden von einer Hubsauger - Vorrichtung ausgeführt die sich auf einer Lafette 4 über die Laufschienen 15 bewegen kann. Die Laufschienen 15 sind über ihre gesamte Länge auf Laufschienenstützen 16 gelagert. Die Laufschienen 15 sind in der Länge veränderbar. Die Laufschienenstützen 16 sind in der Höhe über Stellglieder steuerbar zu verändern. Auf diese Weise kann die erfindungsgemäße Vorrichtung während des Betriebs unterschiedlichen Produktionsverhältnissen angepasst werden.
Als Beispiel für einen solchen Transport ist in der Fig.1 ein photovoltaisches Solarmodul 6 am Beginn des Abnahmeplatzes 1 auf dem entsprechenden, nicht näher bezeichneten, Stapelplatz, eingezeichnet. Die Stapelplätze bei den Abnahmeplätzen A und B sind in der Fig.1 mit 21 und 22 bezeichnet.

Jedem Abnahmeplatz 10,11,12,13 ist ein Leistenleger 19 für Abstandsleisten zugeordnet. Dieser sorgt dafür, dass zwischen aufeinander gelegte Module mindestens 2 Leisten gelegt werden die eine solche Dicke aufweisen, dass die aus der Glasoberfläche eines Moduls herausragenden Bauteile, wie Anschlusskästen oder Modulträger, nicht die Glasoberfläche des benachbarten Moduls verletzen können. Aus Gründen der Übersicht sind in der Fig.1 lediglich am Abnahmeplatz A und B die jeweiligen Leistenleger 19 eingezeichnet.
Jedem Abnahmeplatz 10,11,12,13 ist ferner jeweils ein Folienwickler 7, ein Schutzkappen - Aufleger 8 und eine Umreifungsvorrichtung 9 zugeordnet.
Ein Folienwickler 7 umhüllt die für den Versand bestimmten und aufeinander liegenden Solarmodule 6 mit einer schützenden, und gleichzeitig das Gesamtpaket der Solarmodule 6 zusammenhaltenden, Verpackungsfolie. An zwei gegenüber liegenden Seiten eines Packens von aufeinander liegenden Solarmodulen 6 werden sodann von Schutzkappen - Auflegern 8 Schutzkappen aufgesetzt. Die den einzelnen Abnahmeplätzen 10,11,12,13 vorgelagerten Umreifungsvorrichtungen 9 wirken vorzugsweise im Bereich der Schutzkappen und geben dem jeweiligen Packen Solarmodule 6 den notwendigen Zusammenhalt und machen ihn versandfertig.
Zusätzlich ist das Anbringen eines, das jeweilige Paket versandfertiger Solarmodule 6 kennzeichnenden, "Laufzettels" in druckschriftlicher und / oder elektronischer Form möglich.

Zur Unterstützung der Steuerungsentscheidungen der einzelnen Transportvorgänge befinden sich an relevanten Stellen der erfindungsgemäßen Vorrichtung entsprechende Sensoren und Mittel zur Auswertung der Ausgangssignale der betreffenden Sensoren. Meist handelt es sich hierbei um optische Sensoren jeglicher Art und / oder Näherungssensoren, die der Fachmann entsprechend den örtlichen Gegebenheiten und Anforderungen auswählt.

Sollte in Einzelfällen für ein Solarmodul 6 ein erneuter Durchlauf der Qualitäts - Prüfungseinrichtung 2 notwendig erscheinen, besteht über die in der Fig.1 eingezeichnete Rückführungslinie 17 die Möglichkeit dieses erneut der Produktionslinie 1 zuzuführen. Dies ermöglicht in Einzelfällen, wenn vom Anwender gewünscht, dass ein Solarmodul 6, dessen Prüfung zu einem grenzwertigen Ergebnis führte, von Hand repariert werden kann. Zu diesem Zweck sind in der Fig.1 zwei Winkelförderer 18 dargestellt, die eine solche Rückführung ermöglichen. Der entsprechende Übergabeplatz ist in der Fig.1 mit 23 bezeichnet. Da der Betrieb der gesamten Anlage vollautomatisch abläuft, können Pausen im Produktionsprozess für die erneute Prüfung bestimmter Solarmodule 6 genutzt werden.

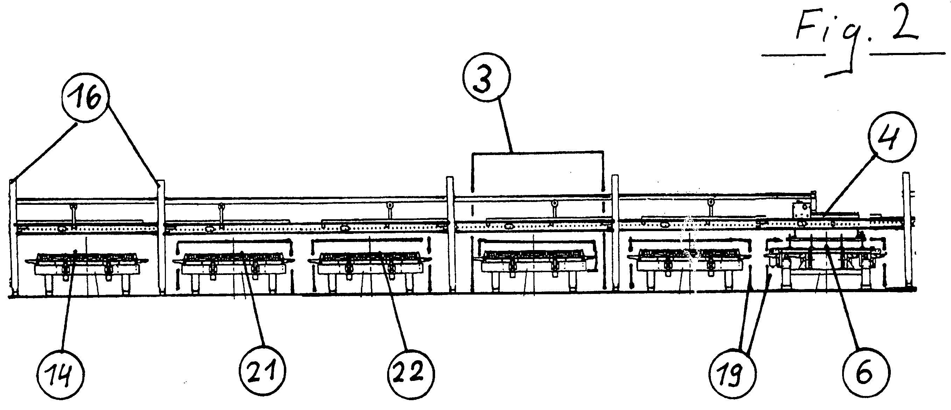

In der Fig.2 ist der nähere Bereich der Umgebung der Laufschiene 15 im Querschnitt dargestellt. Hierbei sind auf der linken Seite zwei Laufschienenstützen 16 links und rechts neben dem Abnahmeplatz 14 für Ausschuss - Module zu erkennen. Rechts davon sind der Stapelplatz A mit dem Bezugszeichen 21 und anschließend der Stapelplatz B mit dem Bezugszeichen 22 im Querschnitt gezeigt. Weiter folgend ist die Montagevorrichtung 3 für Modulträger dargestellt. Im Anschluss daran folgen der Abnahmeplatz C und der Abnahmeplatz A, die beide nicht bezeichnet sind, wobei bei beiden Abnahmeplätzen jeweils ein Leistenleger 19 eingezeichnet ist. Auf dem Abnahmeplatz D ist ein Solarmodul 6 zu erkennen und dahinter liegend beispielhaft die Hubsauger - Lafette 4.

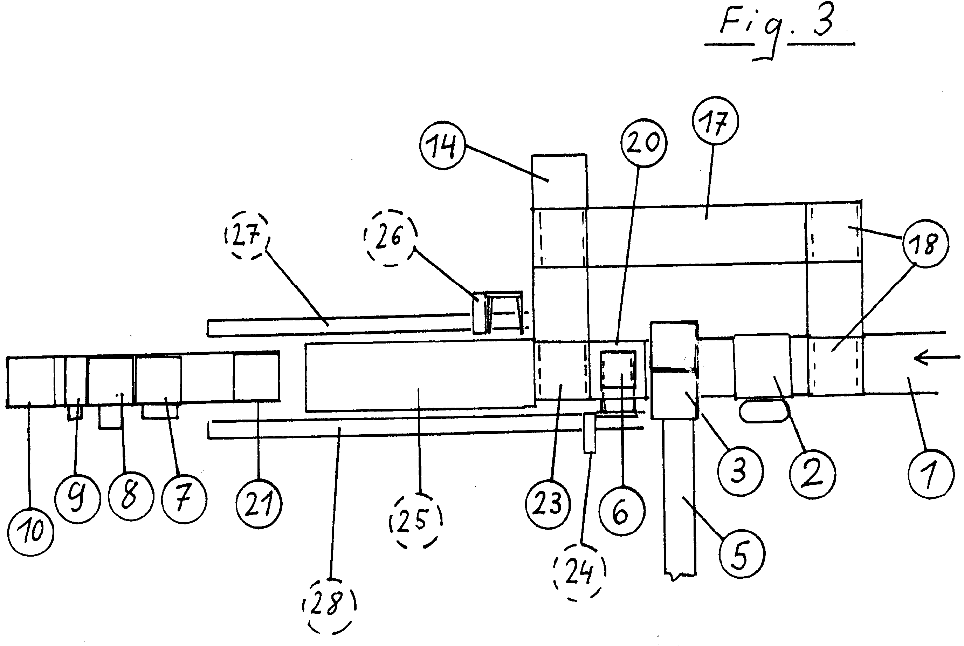

Eine alternative Lösung der, der Erfindung zugrunde liegenden Aufgabe ist in der Fg.3 dargestellt.
Dieser Figur liegt dieselbe Struktur der Vorgänge zum Selektieren und Verpacken von Solarmodulen 6 zugrunde wie sie sich in der Fig. 1 offenbart, wobei zur besseren Darstellung lediglich der Abnahmeplatz D eingezeichnet ist.
Der wesentliche Unterschied zu der Struktur der in der Fig.1 gezeigten Ablauf - Stationen besteht darin, dass die Hubsauger - Lafette 4 mit ihren Laufschienen 15 ersetzt wurde durch einen Speicher 25 mit entsprechenden Vorrichtungen zum Beladen und Entladen dieses Speichers 25.
Das bedeutet, dass die in der Qualitäts - und Prüfeinrichtung 2 klassifizierten Solarmodule 6 nicht direkt den einzelnen Abnahmeplätzen zugeordnet werden sondern zuerst in einem Speicher 25, der auch als Zwischenspeicher bezeichnet werden kann, gelagert werden.
Der Speicher 25 kann hierbei die Solarmodule 6 im Wesentlichen horizontal lagern, als so genannter vertikal orientierter Hochspeicher ausgebildet sein, oder eine Kombination von horizontaler und vertikaler Lagerungsweise aufweisen. Die Bauweise richtet sich hierbei nach den jeweiligen räumlichen Gegebenheiten und Anforderungen des Betreibers der Gesamtanlage. Der Speicher 25 ist vorzugsweise nach beiden Seiten offen und kann somit von vorne und / oder von hinten mit Solarmodulen 6 beladen bzw. entladen werden. Die Vorrichtungen 24 und 26 stehen hierbei für die Möglichkeiten der Beladung und Entladung des Speichers 25. Die zugeordneten Führungsbahnen sind mit 28 und 27 bezeichnet.
Die Kapazität des Speichers 25 ist theoretisch unbeschränkt. Die Anzahl der Abnahmeplätze, die bei der Vorrichtung der Fig.1 mit 4 angenommen wurde, kann natürlich, sowohl bei der Lösung nach der Fig.1 als auch bei der Lösung nach der Fig.3, erheblich höher sein. Die Anzahl der Abnahmeplätze richtet sich dabei in der Hauptsache nach der Anzahl der gewünschten Leistungsklassen. Da die auslieferungsrelevanten Daten jedes Solarmoduls 6 elektronisch diesem zugeordnet werden können, ist es mittels der Vorrichtungen 25,28 möglich die vorgesehenen Abladplätze mit der gewählten Zahl der Solarmodule 6 zu beliefern. Deshalb ist es möglich auch kurzfristig den Umfang eines Auftrags zu ändern. Dies gilt für die Lösung gemäß der Fig.1 als auch der Fig.3.

Die komplexe Steuerung der beschriebenen Bewegungsabläufe erfordert ein spezielles Steuerprogramm.

### Bezugszeichenliste

- (1): Produktionslinie
- (2): Qualitäts - Prüfungseinrichtung
- (3): Montagevorrichtung für Modulträger
- (4): Hubsauger - Lafette
- (5): Versorgungslinie für Modulträger
- (6): Solarmodul
- (7): Folienwickler (Verpackung)
- (8): Schutzkappen - Aufleger
- (9): Umreifungsvorrichtung
- (10): Abnahmeplatz D
- (11): Abnahmeplatz C
- (12): Abnahmeplatz B
- (13): Abnahmeplatz A
- (14): Abnahmeplatz für Ausschuss - Module
- (15): Laufschienen für Hubsauger - Lafette 4
- (16): Laufschienenstützen
- (17): Rückführungslinie (Prüfungswiederholung)
- (18): Winkelförderer
- (19): Leistenleger (Abstandsleisten)
- (20): Aufnahmeplatz der Produktionslinie
- (21): Stapelplatz A
- (22): Stapelplatz B
- (23): Übergabeplatz der Rückführungslinie 17
- (24): Vorrichtung zum Beladen und Entladen
- (25): Speicher als Lagerplatz
- (26): Vorrichtung zum Beladen und Entladen
- (27): Führungsbahn für die Vorrichtung 26
- (28): Führungsbahn für die Vorrichtung 24

## Patentansprüche

1. Vorrichtung zum vollautomatischen Selektieren und Verpacken von photovoltaischen Solarmodulen (6) die in Großserie hergestellt wurden, mit den folgenden Merkmalen:
a) einer Produktionslinie (1),
b) einer Qualitäts-Prüfungseinrichtung (2) mit Vorrichtungen zu mechanischen Endprüfungen und elektrischen Endprüfungen, sowie einer Vorrichtung zur Vergabe eines Bar-Codes,
c) einer Montageeinrichtung (3) für Modulträger,
d) einer Vorrichtung zum Verteilen und Stapeln (4, 15) der Solarmodule (6) in horizontaler und vertikaler Richtung entsprechend bestimmter Auswahlkriterien an, diesen Auswahlkriterien entsprechende, Abnahmeplätze (10, 11, 12, 13), **dadurch gekennzeichnet, dass**
e) die Qualitäts-Prüfungseinrichtung (2) mit der mechanischen Endprüfung optische Geräte, Rütteltest-Geräte und Ultraschall-Geräte und die elektrische Endprüfung Geräte für punktuelle Kälteeinwirkungen und Messgeräte ohmscher und/oder induktiver und/oder kapazitiver Widerstände umfasst,
f) die Vorrichtung zum Verteilen und Stapeln (4, 15) der Solarmodule (6) eine Hubsauger-Lafette (4) mit einer Laufschiene (15) enthält, die Solarmodule (5) horizontal und vertikal bewegen kann, die Laufschiene (15) beliebig verlängerbar und Laufschienenstützen (16) gesteuert in der Höhe verstellbar sind,
g) eine Vorrichtung zum Legen von Leisten (19) als Abstandshalter zwischen gestapelten Modulen (6) ein Magazin aufweist, aus dem unterschiedliche Arten von Leisten entnommen werden können, und wobei das Magazin der als Abstandshalter wirkenden Leisten nicht nur Leisten verschiedener Dicke und Länge sondern auch Leisten aus unterschiedlichen Materialien und Härtegrade enthält,
h) Vorrichtungen zum Zusammenstellen von Packungen aus mehreren Solarmodulen (6) an jedem Abnahmeplatz (10, 11, 12, 13) jeweils einen Folienwickler (7), einen Schutzkappen-Aufleger (8) und eine Umreifungsvorrichtung (9) umfassen,
i) eine Rückführungslinie (17) über Winkelförderer (18) zum Transport von Solarmodulen (6) auf die Fertigungslinie (1) vorgesehen ist.

2. Verfahren zum vollautomatischen Selektieren und Verpacken von photovoltaischen Solarmodulen (6) die in Großserie hergestellt wurden, mit den folgenden Merkmalen:
a) auf einer Produktionslinie (1) werden aus laufender Fertigung Solarmodule (6) unterschiedlicher Qualität angeliefert,
b) die gelieferten Solarmodule (6) durchlaufen eine Qualitäts-Prüfungseinrichtung (2) mit Vorrichtungen zu mechanischen Endprüfungen und elektrischen Endprüfungen, sowie einer Vorrichtung zur Vergabe einer elektronischen Kennung entsprechend der ermittelten Qualitätsstufe, wobei sie zum Verpacken nur weiterbefördert werden, wenn die entsprechenden Prüfungen erfolgreich absolviert wurden, andernfalls werden sie zum Stapelplatz (14) für Ausschuss-Module befördert,
c) entsprechend der ermittelten Qualitätsstufe werden die Solarmodule (6) entsprechenden Abnehmern zugeordnet und mit, vom jeweiligen Abnehmer gewünschten, Modulträgern versehen, oder nach Wunsch auch ohne Modulträger belassen,
d) die somit fertigen Solarmodule werden sodann von einem Hubsauger aufgenommen und entsprechend ihrer Qualitätsklasse und/oder ihrem Abnehmer an die entsprechenden Abnahmeplätze (10, 11, 12, 13) über die Laufschienen (15) befördert und dort übereinander gestapelt,
e) auf den Abnahmeplätzen (10, 11, 12, 13) werden auf jedes abgelegte Solarmodul (6) solange automatisch Leisten als Abstandshalter gelegt bis die gewünschte Lieferung komplett ist,
f) eine komplette Lieferung wird von einem Folienwickler (7) umhüllt, sodann von einem Schutzkappen-Aufleger an zwei Seiten oder auch an allen vier Seiten mit einer Schutzkappe versehen und abschließend im Bereich der Schutzkappen von einer Umreifungsvorrichtung (9) unter Spannung mit bandförmigem Verpackungsmaterial zusammengefasst.

3. Verfahren nach Anspruch 2, **dadurch gekennzeichnet, dass** eine Rückführungslinie (17) über Winkelförderer (18) zum Transport von Solarmodulen (6) auf die Fertigungslinie (1) vorgesehen ist, wobei dieser Weg für Solarmodule (6) offen steht, die die Qualitäts-Prüfungseinrichtung (2) mit einem, ganz oder teilweisen, eine Reparatur rechtfertigenden, negativen Ergebnis durchlaufen haben.

4. Verfahren nach einem der Ansprüche 2 oder 3, **dadurch gekennzeichnet, dass** die mechanische Endprüfung optische Untersuchungen, Rütteltests und Untersuchungen mit Ultraschall und die elektrische Endprüfung punktuelle Kälteeinwirkungen und folgende Messungen ohmscher und/oder induktiver und/oder kapazitiver Widerstände umfasst.

5. Verfahren nach einem der Ansprüche 2 bis 4, **dadurch gekennzeichnet, dass** die Modulträger aus unterschiedlichen Materialien bestehen und bei der Befestigung auf dem Modul unterschiedliche Verfahren der Befestigung verwendet werden.

6. Verfahren nach einem der Ansprüche 2 bis 5, **dadurch gekennzeichnet, dass** das Verteilen und Stapeln der Module mittels einer Hubsauger-Lafette (4) auf einer Laufschiene (15) erfolgt, wobei der Hubsauger Solarmodule (6) horizontal und vertikal bewegen kann und die Laufschiene (15) beliebig verlängerbar und die Laufschienenstützen (16) gesteuert in der Höhe verstellbar sind.

7. Verfahren nach einem der Ansprüche 2 bis 6, **dadurch gekennzeichnet, dass** die Vorrichtung zum Zusammenstellen von Packungen die gestapelten Solarmodule (6) in Folie einhüllt und diese verschweißt und/oder die gestapelten Solarmodule (6) mit aufsteckbaren Kappen aus Verpackungsmaterial versieht, wobei das so entstandene Paket in der Umreifungsvorrichtung (9) mit bandförmigem Verpackungsmaterial mit einer bestimmten, einstellbaren Zugkraft verbunden wird.

## Claims

1. Device for fully automatically selecting and packing photovoltaic solar modules (6) which were produced in large batches, having the following features:
a) a production line (1),
b) a quality testing device (2) having devices for mechanical final tests and electrical final tests as well as a device for allocating a barcode,
c) an assembly device (3) for module carriers,
d) a device for distributing and stacking (4, 15) the solar modules (6) in the horizontal and vertical directions according to particular selection criteria at removal stations (10, 11, 12, 13) corresponding to these selection criteria, **characterized in that**
e) the quality testing device (2) having the mechanical final test comprises optical devices, vibration test devices and ultrasonic devices and the electrical final test comprises devices for the effects of cold at certain points and devices for measuring resistive and/or inductive and/or capacitive impedances,
f) the device for distributing and stacking (4, 15) the solar modules (6) contains a lifting sucker mount (4) having a running rail (15) which is able to move solar modules (6) horizontally and vertically, the running rail (15) is able to be lengthened as desired and the height of the running rail supports (16) is able to be adjusted in a controlled manner,
g) a device for laying strips (19) as spacers between stacked modules (6) has a magazine from which different types of strips are able to be removed, and wherein the magazine containing the strips which act as spacers contains not only strips of different thickness and length but also strips of different materials and degrees of hardness,
h) devices for assembling packages from a plurality of solar modules (6) at each removal station (10, 11, 12, 13) each comprise a film winder (7), a protective cap applicator (8) and a strapping device (9),
i) a return line (17) via angle conveyors (18) for transporting solar modules (6) onto the production line (1) is provided.

2. Method for fully automatically selecting and packing photovoltaic solar modules (6) which were produced in large batches, having the following features:
a) solar modules (6) of different quality are delivered on a production line (1) from ongoing production,
b) the delivered solar modules (6) pass through a quality testing device (2) having devices for mechanical final tests and electrical final tests as well as a device for allocating an electronic identifier according to the quality level determined, said modules being conveyed onward for packing only when the corresponding tests have been successfully passed and otherwise being conveyed to the stacking station (14) for reject modules,
c) the solar modules (6) are assigned to corresponding customers according to the quality level determined and are provided with module carriers desired by the respective customer or else are left without a module carrier if desired,
d) the solar modules which are thus finished are then picked up by a lifting sucker and are conveyed, via the running rails (15), to the corresponding removal stations (10, 11, 12, 13) according to their quality class and/or their customer and are stacked on top of one another in said stations,
e) in the removal stations (10, 11, 12, 13), strips are automatically laid, as spacers, onto each stored solar module (6) until the desired delivery is complete,
f) a complete delivery is wrapped by a film winder (7), is then provided with a protective cap on two sides or else on all four sides by a protective cap applicator and is finally combined with strip-like packaging material in the region of the protective caps under stress by a strapping device (9).

3. Method according to Claim 2, **characterized in that** a return line (17) via angle conveyors (18) for transporting solar modules (6) onto the production line (1) is provided, this path being open to solar modules (6) which have passed through the quality testing device (2) with an entirely or partially negative result which warrants repair.

4. Method according to one of Claims 2 and 3, **characterized in that** the mechanical final test comprises optical investigations, vibration tests and investigations with ultrasound and the electrical final test comprises the effects of cold at certain points and subsequent measurements of resistive and/or inductive and/or capacitive impedances.

5. Method according to one of Claims 2 to 4, **characterized in that** the module carriers consist of different materials and different fastening methods are used when fastening said carrier to the module.

6. Method according to one of Claims 2 to 5, **characterized in that** the modules are distributed and stacked using a lifting sucker mount (4) on a running rail (15), the lifting sucker being able to move solar modules (6) horizontally and vertically, the running rail (15) being able to be lengthened as desired and the height of the running rail supports (16) being able to be adjusted in a controlled manner.

7. Method according to one of Claims 2 to 6, **characterized in that** the device for assembling packages wraps the stacked solar modules (6) in film and welds them and/or provides the stacked solar modules (6) with caps which are made of packaging material and can be plugged on, the package produced in this manner being connected to strip-like packaging material with a particular, adjustable tensile force in the strapping device (9).

## Revendications

1. Dispositif de sélection et d'emballage entièrement automatiques de modules solaires photovoltaïques (6) qui ont été fabriqués en grande série, comprenant les caractéristiques suivantes :
a) une chaîne de production (1),
b) un dispositif de contrôle de qualité (2) avec des dispositifs de contrôles mécaniques finaux et de contrôles électriques finaux, ainsi qu'un dispositif pour attribuer un code à barres,
c) un dispositif de montage (3) pour des supports de modules,
d) un dispositif de distribution et d'empilement (4, 15) des modules solaires (6) dans la direction horizontale et verticale en fonction de critères de sélection déterminés à des emplacements de prélèvement (10, 11, 12, 13) correspondant à ces critères de sélection, **caractérisé en ce que**
e) le dispositif de contrôle de qualité (2) avec le contrôle mécanique final comprend des appareils optiques, des appareils d'essais de vibrations et des appareils à ultrasons et le contrôle électrique final comprend des appareils pour des applications de froid ponctuelles et des appareils de mesure de résistances ohmiques et/ou inductives et/ou capacitives,
f) le dispositif de distribution et d'empilement (4, 15) des modules solaires (6) contient une plate-forme pour élévateur aspirant (4) avec un rail de roulement (15) qui peut déplacer les modules solaires (5) horizontalement et verticalement, le rail de roulement (15) pouvant être prolongé de manière quelconque et des supports de rail de roulement (16) pouvant être déplacés en hauteur de manière commandée,
g) un dispositif pour poser des profilés (19) en tant qu'élément d'espacement entre des modules empilés (6) présente un magasin depuis lequel peuvent être retirés différents types de profilés, et le magasin de profilés servant d'éléments d'espacement contenant non seulement des profilés d'épaisseurs et de longueurs différentes mais également des profilés de matériaux et de qualités de dureté différents,
h) des dispositifs pour assembler des emballages constitués de plusieurs modules solaires (6) au niveau de chaque emplacement de prélèvement (10, 11, 12, 13) comprennent à chaque fois un enrouleur de film (7), un dispositif de pose de recouvrements de protection (8) et un dispositif de cerclage (9), et
i) une chaîne de retour (17) par le biais de transporteurs angulaires (18) est prévue pour le transport de modules solaires (6) sur la chaîne de fabrication (1).

2. Procédé de sélection et d'emballage entièrement automatiques de modules solaires photovoltaïques (6) qui ont été fabriqués en grande série, comprenant les caractéristiques suivantes :
a) des modules solaires (6) de qualités différentes sont fournis sur une chaîne de production (1) à partir d'une fabrication en continu,
b) les modules solaires fournis (6) passent par un dispositif de contrôle de qualité (2) avec des dispositifs de contrôles mécaniques finaux et de contrôles électriques finaux, ainsi qu'un dispositif pour attribuer un marquage électronique en fonction du niveau de qualité déterminé, les modules solaires n'étant transférés en vue de leur emballage que si les contrôles correspondants ont été effectués avec succès, sinon ils sont transportés vers un emplacement d'empilement (14) pour les modules à rejeter,
c) en fonction du niveau de qualité déterminé, les modules solaires (6) sont associés à des acheteurs correspondants et sont pourvus de supports de modules souhaités par chaque acheteur ou, selon les souhaits, sont aussi laissés sans supports de modules,
d) les modules solaires ainsi fabriqués sont ensuite reçus par un élévateur aspirant et, en fonction de leur classe de qualité et/ou de leur acheteur, sont transportés aux emplacements de prélèvement correspondants (10, 11, 12, 13) par le biais des rails de roulement (15) et y sont empilés les uns sur les autres,
e) sur les emplacements de prélèvement (10, 11, 12, 13) sont placés automatiquement des profilés en tant qu'éléments d'espacement sur chaque module solaire déposé (6) jusqu'à ce que la fourniture souhaitée soit complète,
f) une fourniture complète est enveloppée par un enrouleur de film (7) puis est pourvue d'un recouvrement de protection sur deux côtés ou également sur tous les quatre côtés par un dispositif de pose de recouvrement de protection et ensuite, dans la région du recouvrement de protection, est rassemblée par un dispositif de cerclage (9) avec serrage par un matériau d'emballage en forme de bande.

3. Procédé selon la revendication 2, **caractérisé en ce qu'**une chaîne de retour (17) est prévue par le biais de transporteurs angulaires (18) pour le transport de modules solaires (6) sur la chaîne de fabrication (1), cette voie restant ouverte pour des modules solaires (6) qui ont passé le dispositif de contrôle de qualité (2) avec un résultat négatif nécessitant une réparation, complètement ou partiellement.

4. Procédé selon l'une quelconque des revendications 2 ou 3, **caractérisé en ce que** le contrôle mécanique final comprend des essais optiques, des essais de vibrations et des essais avec des ultrasons et le contrôle électrique final comprend des applications de froid ponctuelles et des mesures suivantes de résistances ohmiques et/ou inductives et/ou capacitives.

5. Procédé selon l'une quelconque des revendications 2 à 4, **caractérisé en ce que** les supports de modules se composent de matériaux différents et lors de la fixation sur le module, différents procédés de fixation sont utilisés.

6. Procédé selon l'une quelconque des revendications 2 à 5, **caractérisé en ce que** la distribution et l'empilement des modules s'effectue au moyen d'une plate-forme pour élévateur aspirant (4) sur un rail de roulement (15), l'élévateur aspirant pouvant déplacer horizontalement et verticalement les modules solaires (6) et le rail de roulement (15) pouvant être prolongé de manière quelconque et les supports de rail de roulement (16) pouvant être déplacés en hauteur de manière commandée.

7. Procédé selon l'une quelconque des revendications 2 à 6, **caractérisé en ce que** le dispositif pour assembler les emballages enveloppe les modules solaires empilés (6) dans un film et soude ce dernier et/ou fournit aux modules solaires empilés (6) des recouvrements enfichables constitués de matériau d'emballage, le paquet ainsi produit étant assemblé dans le dispositif de cerclage (9) avec un matériau d'emballage en forme de bande avec une force de traction déterminée ajustable.
